# EUROPÄISCHE PATENTANMELDUNG

(11) **EP 0 753 922 A2**
(43) Veröffentlichungstag der Anmeldung: **15.01.1997**
(21) Anmeldenummer: 96105979.7
(22) Anmeldetag: 17.04.1996
(51) Int. Cl.: H02H 1/06, H02H 3/06

(54) **Schaltungsanordnung zum Aufladen eines Kondensators**

(30) Priorität: 08.07.1995 DE 19524962
(71) Anmelder: ROBERT BOSCH GMBH, 70442 Stuttgart (DE)
(72) Erfinder: Kessler, Martin, Dipl.-Ing., 77815 Bühl (DE)

(57) **Zusammenfassung**

Die Erfindung betrifft eine Schaltungsanordnung zum Aufladen eines Kondensators, insbesondere zum Einschalten der Spannungsversorgung eines Elektromotors, wobei der Kondensator einerseits an einem Anschluß niedrigen oder höheren Potentials liegt und andererseits mittels eines Schaltmittels über einen Ladewiderstand mit einem Anschluß höheren oder niederen Potentials verbindbar ist.

Es ist vorgesehen, daß der Ladewiderstand (R1) zum niederohmigen Aufladen des Kondensators (C) von einer Aufladeschaltung (26) überbrückt wird.

## Beschreibung

Die Erfindung betrifft eine Schaltungsanordnung zum Aufladen eines Kondensators, insbesondere zum Einschalten der Spannungsversorgung eines Elektromotors, nach dem Oberbegriff des Anspruchs 1.

### Stand der Technik

Es ist bekannt, in Kraftfahrzeugen eine Reihe von Ausstattungen mittels elektromotorischer Verstellsysteme zu betreiben. Diese Ausstattungen, beispielsweise Fensterheber, Sitzverstellungen, Hub- und Schiebedächer usw., sind mittels Elektromotoren betätigbar. Den Elektromotoren sind Schutzschaltungen zugeordnet, die bei plötzlich auftretender Schwergängigkeit der Verstellorgane oder bei Hindernissen in der Verstellbahn die Elektromotoren ausschalten, um irreparable thermische Bechädigungen an den Elektromotoren zu vermeiden. Eine derartige Schutzschaltung ist beispielsweise aus der DE-OS 42 16 040 bekannt. Hierbei wird der Elektromotor bei Erreichen eines bestimmten Schwellwertes der Motorverlustleistung abgeschaltet, um eine Abkühlung zu erreichen. In einer wählbaren, vorgebbaren Zeitspanne erfolgt ein Wiedereinschalten des Elektromotors. Dieses Ab- und Zuschalten des Elektromotors kann während eines Verstellvorganges mehrfach erfolgen, sofern die Schwergängigkeit des Verstellsystems nicht beseitigt ist. Zur Bestimmung des Wiedereinschaltvorgangs des Elektromotors ist es bekannt, eine Schaltungsanordnung einzusetzen, die einen Kondensator enthält, der über einen Ladewiderstand aufgeladen wird. Erreicht die Spannung des Kondensators eine wählbare Schwellspannung, kann das Erreichen der Schwellspannung zum Bereitstellen eines Einschaltimpulses für den Elektromotor genutzt werden. Hierbei ist nachteilig, daß der Kondensator über den Ladewiderstand aufgrund dessen Hochohmigkeit nur mit einer Zeitkonstante aufgeladen werden kann. Hierdurch stellt sich eine Verzögerungszeit ein, die das Wiedereinschalten des Elektromotors ebenfalls verzögert. Es kommt zu einem Gegensatz zwischen einer großen Zeitkonstante beim Blockieren des Elektromotors und einer kleinen Zeitkonstante beim Wiedereinschalten.

### Vorteile der Erfindung

Die erfindungsgemäße Schaltungsanordnung mit den im Anspruch 1 genannten Merkmalen bietet demgegenüber den Vorteil, daß der Kondensator schneller aufgeladen wird und sich damit die Verzögerungszeit, mit der der Elektromotor wieder eingeschaltet wird, minimiert.

Dadurch, daß der Ladewiderstand zum niederohmigen Aufladen des Kondensators von einer Aufladeschaltung überbrückt wird, die vorzugsweise einen Transistor aufweist, dessen Emitter mit der Gleichspannungsquelle und dessen Kollektor über einen Strombegrenzungswiderstand mit dem Kondensator verbunden ist, erfolgt das Aufladen des Kondensators nach Einschalten der Gleichspannungsquelle im wesentlichen verzögerungsfrei. Der hochohmige Ladewiderstand wird vorteilhafterweise durch den niederohmigen Schaltweg über den Transistor und den Strombegrenzungswiderstand überbrückt, so daß anstelle eines hochohmigen Aufladens ein niederohmiges Aufladen des Kondensators erfolgt.

Weitere vorteilhafte Ausgestaltungen der Erfindung ergeben sich aus den übrigen in den Unteransprüchen genannten Merkmalen.

### Zeichnungen

Die Erfindung wird nachfolgend in einem Ausführungsbeispiel anhand der zugehörigen Zeichnungen näher erläutert. Es zeigen:
- Figur 1: ein Prinzipschaltbild der Aufladung eines Kondensators und
- Figur 2: eine mit der erfindungsgemäße Aufladeschaltung versehene Schaltungsanordnung.

### Beschreibung der Ausführungsbeispiele

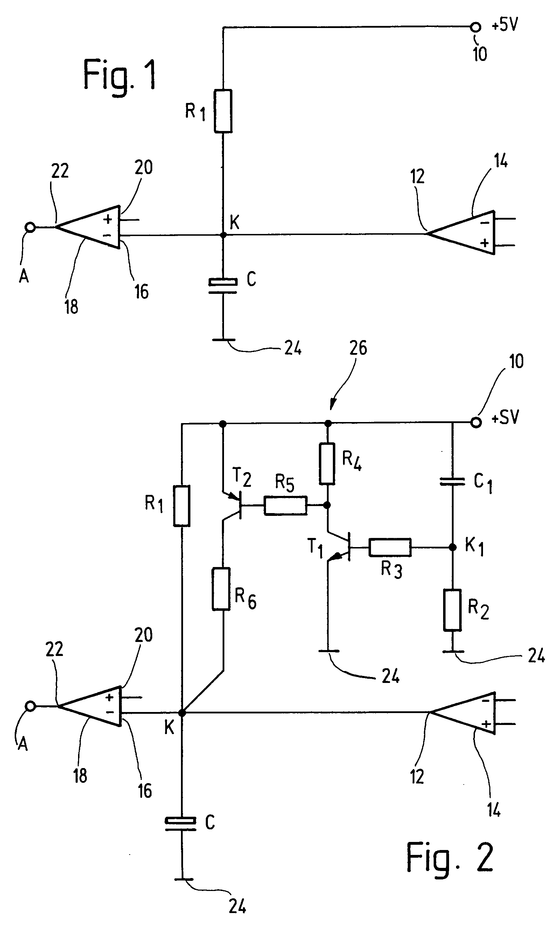

Anhand des in Figur 1 gezeigten Prinzipschaltbildes wird das Aufladen eines Kondensators C verdeutlicht. Der Kondensator C ist mit seinem einen Anschluß mit einem Knotenpunkt K verbunden. Der Knotenpunkt K ist über einen Widerstand R1 mit einem positiven Potentialanschluß 10 einer Gleichspannungsquelle verbunden. Der Knotenpunkt K ist weiterhin mit dem Ausgang 12 eines ersten als Komparator 14 ausgebildeten Operationsverstärkers verbunden. Der nichtinversive und der inversive Eingang des Komperators 14 sind mit einer hier nicht näher dargestellten Schaltung verbunden. Ferner ist der Knoten K mit dem inversiven Eingang 16 eines zweiten als Komparator 18 ausgebildeten Operationsverstärkers verbunden. Der nichtinversive Eingang 20 des Komparators 18 ist mit einem Potential verbunden, welches zwischen dem Potential der Anschlüsse 10 und 24 liegt. Ein Ausgang 22 des Komparators 18 ist mit einem Ausgang A der Schaltungsanordnung verbunden. Der zweite Anschluß des Kondensators C ist mit einem Anschluß 24 verbunden, dessen Potential niedriger als das Potential der Potentialanschlußklemme 10 ist.

Die in Figur 1 gezeigte Schaltungsanordnung übt folgende Funktion aus:

Im Ausgangszustand der Schaltung ist der Ausgang 12 des Komparators 14 niederohmig. Stellt nunmehr die an dem Komparator 14 - hier nicht näher dargestellte Schaltung - ein Schaltsignal bereit, schaltet der Komparator 14 seinen Ausgang 12 auf hochohmig um. Infolgedessen liegt das Potential der positiven Potentialanschlußklemme 10 an dem mit dem Knotenpunkt K verbundenen Kontakt des Kondensators C über den Widerstand R1 an. Durch den Potentialunterschied zwischen der Potentialanschlußklemme 10 und dem Anschluß 24 wird der Kondensator C aufgeladen. Durch den hochohmigen Widerstand R1, der als Ladewiderstand fungiert, erfolgt die Aufladung mit einer widerstandsabhängigen Zeitkonstante. Die Ladespannung des Kondensators C liegt gleichzeitig an dem inversiven Eingang 16 des Komparators 18 an. Der Komparator 18 vergleicht die Ladespannung des Kondensators C mit dem am nichtinversiven Eingang 20 anliegenden positiven Potential. Erreicht die Ladespannung des Kondensators C das Potential des nichtinvertierenden Eingangs 20, wird am Ausgang 22 des Komparators ein Signal generiert, das gleichzeitig an der Anschlußklemme A anliegt. Durch die Änderung des Schaltzustandes am Anschluß A kann beispielsweise in hier nicht näher zu betrachtender Weise eine Spannungsversorgung eines Elektromotors eingeschaltet werden. Durch die widerstandsabhängige Zeitkonstante wird der Kondensator C während des Aufladens ebenfalls mit dieser Zeitkonstante verzögert aufgeladen, so daß am Ausgangsanschluß A das Signal mit einer entsprechenden Verzögerungszeit anliegt.

In der Figur 2 ist die Schaltungsanordnung um eine Aufladeschaltung 26 ergänzt dargestellt. Gleiche Teile wie in Figur 1 sind mit gleichen Bezugszeichen versehen und nicht nochmals erläutert.

Der Potentialanschluß 10 ist mit einem als Hochpaß ausgebildetem RC-Glied des Widerstandes R2 und des Kondensators C1 verbunden. Ein Knoten K1 des RC-Gliedes ist über einen Widerstand R3 mit der Basis eines ersten Transistors T1 verbunden. Der Emitter des npn-Transistors T1 ist mit einem Potential verbunden, das dem des Anschlusses 24 entspricht, und der Kollektor ist über einen Widerstand R4 mit dem Potentialanschluß 10 verbunden. Der Kollektor des Transistors T1 ist weiterhin über einen Widerstand R5 mit der Basis eines zweiten Transistors T2 verbunden. Der Emitter des pnp-Transistors T2 ist ebenfalls mit dem Potentialanschluß 10 verbunden. Der Kollektor des zweiten Transistors T2 ist über einen Widerstand R6 mit dem Knoten K verbunden.

Die in der Figur 2 gezeigte Aufladeschaltung 26 übt folgende Funktion aus:

Über den von dem Kondensator C1 und dem Widerstand R2 gebildeten Hochpaß wird das Anlegen des positiven Potentials von +5V an dem Potentialanschluß 10 detektiert. Hierdurch wird die Basis des Transistors T1 angesteuert, so daß dieser leitend wird. Der Transistor T1 schaltet somit durch und schaltet gleichzeitig den im Ausgangszustand gesperrten Transistor T2 ein. Hierdurch erfolgt eine elektrisch leitende Verbindung zwischen dem Knoten K über den Widerstand R6 und den Transistor T2 mit dem Potentialanschluß 10. Der Transistor T2 und der als Strombegrenzungswiderstand dienende Widerstand R6 überbrücken somit den Ladewiderstand R1. Über den Widerstand R6 und den Transistor T2 erfolgt eine niederohmige Verbindung des Knotens K mit dem Potentialanschluß 10, so daß die widerstandsabhängige Zeitkonstante, mit der das Aufladen des Kondensators C erfolgt, minimiert ist. Hierdurch wird der Kondensator C schneller aufgeladen, was wiederum zu einem schnelleren Erreichen der Schwellspannung führt, so daß der Komparator 18 entsprechend schneller das Ausgangssignal an der Anschlußklemme A bereitstellt. Die Verzögerungszeit, innerhalb der nach Auslösung der Aufladeschaltung 26 ein Ausgangssignal an der Anschlußklemme A bereitsteht, ist somit minimiert, so daß eine Wiedereinschaltung eines Elektromotors über das an der Anschlußklemme A anliegende Signal entsprechend schneller erfolgen kann.

## Patentansprüche

1. Schaltungsanordnung zum Aufladen eines Kondensators, insbesondere zum Einschalten der Spannungsversorgung eines Elektromotors, wobei der Kondensator einerseits an einem Anschluß niedrigen oder höheren Potentials liegt und andererseits mittels eines Schaltmittels über einen Ladewiderstand mit einem Anschluß höheren oder niederen Potentials verbindbar ist, **dadurch gekennzeichnet**, daß der Ladewiderstand (R1) zum niederohmigen Aufladen des Kondensators (C) von einer Aufladeschaltung (26) überbrückt wird.

2. Schaltungsanordnung nach Anspruch 1, **dadurch gekennzeichnet**, daß die Aufladeschaltung (26) ein den Ladewiderstand (R1) überbrückendes Schaltmittel aufweist.

3. Schaltungsanordnung nach einem der vorhergehenden Ansprüche, **dadurch gekennzeichnet**, daß die Aufladeschaltung (26) wenigstens einen parallel zum Ladewiderstand (R1) geschalteten Transistor (T2) aufweist, dessen Emitter mit dem Anschluß (10) höheren Potentials und dessen Kollektor über einen Strombegrenzungswiderstand (R6) mit dem Kondensator (C) verbunden ist.

4. Schaltungsanordnung nach einem der vorhergehenden Ansprüche, **dadurch gekennzeichnet**, daß die Basis des Transistors (T2) über einen zweiten Transistor (T1) angesteuert wird, dessen Basis über einen Hochpaß (C1, R2) mit dem Anschluß (10) verbunden ist.

5. Schaltungsanordnung nach einem der vorhergehenden Ansprüche, **dadurch gekennzeichnet**, daß der Kondensator (C) mit dem inversiven Eingang (16) eines Komparators (18) verbunden ist, dessen Ausgang (22) ein Einschaltsignal für einen Elektromotor bereitstellt.

6. Schaltungsanordnung nach Anspruch 2, **dadurch gekennzeichnet**, daß das Schaltmittel ein Relais ist.

7. Schaltungsanordnung nach Anspruch 2, **dadurch gekennzeichnet**, daß das Schaltmittel ein MOS-FET-Transistor ist.
